(19)

Europäisches
Patentamt

European
Patent Office

Office européen
des brevets

(11) **EP 2 218 743 A1**

(12) **EUROPÄISCHE PATENTANMELDUNG**

(43) Veröffentlichungstag:
**18.08.2010 Patentblatt 2010/33**

(21) Anmeldenummer: **09001951.4**

(22) Anmeldetag: **12.02.2009**

(51) Int Cl.:
*C08G 18/10* (2006.01)     *C08G 18/48* (2006.01)
*C08G 18/67* (2006.01)     *C08G 18/77* (2006.01)
*C08G 18/78* (2006.01)     *G03F 7/00* (2006.01)
*G03F 7/035* (2006.01)     *G11B 7/245* (2006.01)
*G11B 7/246* (2006.01)     *G11B 7/253* (2006.01)

(84) Benannte Vertragsstaaten:
**AT BE BG CH CY CZ DE DK EE ES FI FR GB GR
HR HU IE IS IT LI LT LU LV MC MK MT NL NO PL
PT RO SE SI SK TR**
Benannte Erstreckungsstaaten:
**AL BA RS**

(71) Anmelder: **Bayer MaterialScience AG
51368 Leverkusen (DE)**

(72) Erfinder:
• **Weiser, Marc-Stephan, Dr.
51379 Leverkusen (DE)**
• **Roelle, Thomas, Dr.
51381 Leverkusen (DE)**
• **Bruder, Friedrich-Karl, Dr.
47802 Krefeld (DE)**
• **Fäcke, Thomas, Dr.
51375 Leverkusen (DE)**
• **Hönel, Dennis
53909 Zülpich (DE)**

(54) **Prepolymerbasierte Polyurethanformulierungen zur Herstellung holographischer Filme**

(57)     Die vorliegende Erfindung betrifft ein neuartiges holographisches Photopolymer basierend auf prepolymerbasierten Polyurethanzusammensetzungen, dessen Herstellung und seine Anwendung für optische Anwendungen verschiedenster Art.

EP 2 218 743 A1

**Beschreibung**

Die vorliegende Erfindung betrifft ein neuartiges holographisches Photopolymer basierend auf prepolymerbasierten Polyurethanzusammensetzungen, dessen Herstellung und seine Anwendung für optische Anwendungen verschiedenster Art.

Holographische Medien können unter anderem als Datenspeicher, auf dem Gebiet der Sicherheitstechnologie (beispielsweise der dreidimensionalen Darstellung von Personen oder Dingen sowie der Authentifizierung einer Person oder eines Gegenstandes), der Darstellung von Objekten, der Verwendung als Werbeträger, dem Einsatz als Hilfsmaterialien zur Herstellung komplexer dreidimensionaler Strukturen und als Bildschirm oder als Bauteile von Bildschirmteilen sowie zur Herstellung eines optischen Elements mit der Funktion einer Linse, eines Spiegels, eines Filters, einer Streuscheibe, eines Beugungselementes, eines Lichtleiters und/oder einer Maske eingesetzt werden.

Holographische Medien basierend auf einer Polymermatrix und einem oder mehreren darin eingebetteten radikalisch polymerisierbaren Verbindungen als Schreibmonomeren sind beispielsweise in US 6,743,552 beschrieben.

Aus US 6743552, US 6765061, US 6780546 und US 2006/0194120 sind solche Zweikomponenten-Polyurethanfonnulierungen bekannt. Die dort beschriebenen Formulierungen enthalten zum Teil Prepolymere als Isoeyanat-Komponente, wobei es sich ausschließlich um solche Prepolymere mit sekundären Isocyanatgruppen handelt und daher in der Aushärtgcschwindigkeit unbefriedigend sind.

Polyrnerformulierungen zur Herstellung von holographischen Medien wurden unter anderem in dem nicht vorveröffentlichten Patentanmeldungen EP 08017279.4, EP 08017277.8, EP 08017273.7, EP 08017275.2 beschrieben. In EP 08017277.8 und EP 08017273.7 sind polyetherbasierte und prepolymer-basierte Polyurethanzusammensetzungen beschrieben, die sich zur Herstellung holographischer Medien im Allgemeinen eignen. In EP 08017275.2 wurden Polyurethanformulierungen mit speziellen Acrylaten beschrieben, die zur Aufzeichnung von Hologrammen geeignet sind. Weiterhin wurde in EP 08017279.4 erstmals ein typischer Folienaufbau und die Applikation verschiedener Pulyurethanformulierungen als Photopolymer im Folienverbund beschrieben. Die Anwendung von Prepolymer-basierten Polyurethanformulierungen für eine beschichtete Folie mit der Verbindung einer Farbstoff- / Initiatormischung, die das komplette sichtbare Wellenlängcnspektrum abdeckt (400- 800 nm) ist hingegen nicht vorbeschrieben.

Aufgabe der vorliegenden Erfindung war es Polyurethanzusammensetzungen bereitzustellen, aus welchen sich holographische Photopolymere mit guter Oberflächenqualitiil und guter Verarbeitbarkeit herstellen lassen, die zudem einen guten Brechungsindexkontrast aufweisen.

Es wurde nun überraschenderweise gefunden, dass sich die oben genannten Anforderungen erfüllen lassen, wenn prepolymer-basierte Potyurcthanzusammensetzungen in Verbindung mit bestimmten Polyetherpolyolen als Matrixmaterialien sowie spezielle hochbrechende Urethanacrylate mit mindestens einer aromatischen Struktureinheit als Schreibmonornere eingesetzt werden.

Gegenstand der Erfindung sind daher Poiyurethanzusammensetzungen, umfassend

A) eine Potyisocyanatkomponente, wenigstens enthaltend ein NCO-terminiertes Polyurethanprepolymer dessen NCO-Gruppen primär aliphatisch gebunden sind und welches auf hydroxyfunktionellen Verbindungen mit einer OH-Funktionalität von 1,6 bis 2,05 basiert,

B) Isoeyanat-reaktive Polyetherpolyole

C) Urethanacrylate utid/oder Urethanmethacrylate mit mindestens einer aromatischen Struktureinheit und einem Brechungsindex von größer 1,50 bei 405 nm, die selbst frei von NCO-Gruppen und OH-Gruppen sind

D) Radikalstabilisatoren

E) Photoinitiatoren auf Basis von Kombinationen aus Boratsalzen und einem oder mehreren Farbstoffen mit Absorptionsbanden, die zumindest teilweise den Spektralbereich von 400 bis 800 nm abdecken.

F) gegebenenfalls Katalysatoren

G) gegebenenfalls Hilfs- und Zusatzstoffe.

Die erfindungswesentlichen Prepolymere der Komponente A) werden in dem Fachmann an sich gut bekannter Art und Weise durch Umsetzung von monomeren, oligomeren oder Polyisocyanaten A1) mit isocyanatreaktiven Verbindungen A2) in geeigneter Stöchiometrie unter optionalem Einsatz von Katalysatoren und Lösemitteln erhalten.

Auf diese Weise können NCO-funktionelle Prepolymere mit Urethan-, Allophanat-, Biuret- und/oder Amidgruppen hergestellt werden.

Als Polyisocyanate A1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Hanistoff-, Carbodiimid-, Acylharnstof-, Isocyanurat-, Allophanat-, Biuret-, Oxadiazintrion-, Uretdion-, lminooxadiazindionstruktur jeweils einzeln oder in beliebigen Mischungen untereinander eingesetzt werden.

Bevorzugte monomere Di- oder Triisocyanate, die als Komponente A1) eingesetzt werden können, sind Butendiisocyanat, Hexamethylendiisocyanat (HDI), Isophorondiisocyanat (IPDI), Trimethyl-hexamethylen-diisocyanat (TMDI), und/oder Isocyanatomethyl-1,8-octandiisocyanat (TIN). Besonders bevorzugt sind TIN, TMDI und HDI und ganz besonders bevorzugt ist HDI.

Als isocyanatreaktive Verbindungen A2) zum Aufbau der Prepolymere werden OH-funktionelle Verbindungen mit einer OH-Funktionalität von bevorzugt 1,9 bis 2,01, besonders bevorzugt 2,0 eingesetzt.

Geeignet hierfür sind oligomere oder polymere Isocyanat-reaktive Verbindungen des vorstehend genannten Funktionalitätsbereichs wie niedermolekulare kurzkettige, d.h. 2 bis 20 Kohlenstoffatome enthaltende aliphatische, araliphatische oder cycloaliphatische Diole. Beispiele für solche Diole sind Ethylenglykol, Diethylenglykol, Triethylenglykol, Tetraethylenglykol, Dipropylenglykol, Tripropylenglykol, 1,2-Yropandiol, 1,3-Prupandiol, 1,4-Butandiol, Neopentylglykol, 2-Ethyl-2-butylpropandiol, Trimethylpentandiol, stellungsisomere Diethytoetandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsliure(2,2-dimethyl-3-hydroxypropylester).

Geeignet sind auch höhermolekulare aliphatische und cycloaliphatische Polyole des vorstehend genannten Funktionalitätsbereichs wie Polyesterpolyole, Polyetherpolyole, Polycarbonatpolyole, hydroxyfunktionelle Acrylharze, hydroxyfunktionelle Polyurethane, hydroxyfunktionelle Epoxyharze oder entsprechende Hybride.

Als solche Polyetherpolyole seien z. B. die difunktionellen Polyadditionsprodukte des Ethylenoxid, Propylenoxid, Tetrahydrofuran, Butylenoxid, sowie ihre Mischadditions- und Pfropfprodukte, sowie die durch Kondensation von zweiwertigen Alkoholen oder Mischungen derselben und die durch Alkoxylierung von zweiwertigen Alkoholen gewonnenen Polyetherpolyole. Bevorzugte difunktionelle Polyetherpolyole sind Poly(propylenoxid)e, Poly(ethylenoxide) und deren Kombinationen in Form von statistischen oder Blockcopolymeren sowie Mischungen derselben mit einer zahlenmittleren Molmasse zwischen 200 und 18000 g/Mol, besonders bevorzugt mit einer zahlenmittleren Molmasse zwischen 600 und 8000 g/Mol und ganz besonders bevorzugt mit einer zahlenmittleten Molmasse zwischen 1000 und 4500 g/Mol.

Besonders bevorzugt werden als A2) Poly(propylenoxid)e des vorstehend genannten Funktionalitätsbereichs mit zahlenmittleren Molmassen zwischen 650 g/mol und 4500 g/mol, besonders bevorzugt mit zahlenmittleren Molmassen zwischen 1000 g/mol und 4100 g/mol und ganz besonders bevorzugt mit zahlenmittleren Molmassen zwischen 1900 g/mol und 2100 g/mol eingesetzt.

Beim Prepotymeraufbau wird zur Urethanisierung Isocyanat gemäß A1) mit Alkohol gemäß A2) in stöchiometrischen Mengen umgesetzt, wobei eine Urethangruppe entsteht. Als Alkohole eignen sich in diesem Falle für die Umsetzung mit den erwähnten Di-, Tri- und Polyisocyanaten alle oligomeren oder polymeren, primären oder sekundären, difunktionellen Alkohole der vorstehend genannten Art. Im Rahmen der Urothanprepolymere sind dies bevorzugt Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydtoxycyclohexan, 1,4-Dimethylolcyclohexan, Octandiol-1,8, Decandiol-1,10, Dodecandiol-1,12, Polyethylenglycol, Polypropylenglykol, Block- und/oder Copolymere aus Ethylenoxid und Propylenoxid und/oder anderen 1-Alkenoxiden, Poty(THF), Polyester-, Polycarbonat- und Polyacrylatpolyole mit zahlenmittleren Molmassen bis 10000 g/Mol oder deren beliebige Gemische untereinander.

Beim Prepolymeraufbau wird zur Allophanatisierung zunächst ein Isocyanat gemäß A1) mit einem Alkohol gemäß A2) in stöchiometrischem Verhältnis zu einem Urethan umgesetzt, welches anschließend mit einem weiteren Isocyanat umgesetzt wird, wobei ein Allophanat entsteht. Als Alkohol eignen sich in diesem Falle für die Umsetzung mit den erwähnten Di-, Tri- oder Polyisocyanaten zum Urethan alle oligomeren oder polymeren, primären oder sekundären, difunktionellen Alkohole der vorstehend beschriebenen Art. Für die weitere Umsetzung zum Allophanat werden bevorzugt die monomeren Di- oder Triisocyanate HDI, TMDI und TIN zugesetzt.

Bevorzugte Prepolymere sind Urethane oder Allophanate aus aliphatischen Isocyanat-funktionellen Verbindungen und oligomeren oder polymeren Isocyanat-reaktiven Verbindungen, wobei die Prepolymere zahlenmittlere Molmassen von 200 bis 10000 g/Mol und NCO-Funktionalitäten von 1,9 bis 5,0 aufweisen. Besonders bevorzugt sind Urethane mit NCO-Funktionalitäten von 1,9 bis 2,1 und zahlenmittleren Molmassen von 650 bis 8200 g/Mol, hergestellt aus aliphatischen Isocyanat-funktionellen Verbindungen und oligomeren oder polymeren Polyolen und Allophanate mit Funktionalitäten von größer 2,0 bis 3,2 oder von 3,9 bis 4,2.mit zahlenmittleren Molmassen von 650 bis 8200 g/Mol, hergestellt aus aliphatischen Isocyanat-funktionellen Verbindungen und oligomeren oder polymeren Polyolen oder deren beliebige Mischungen. Ganz besonders bevorzugt sind Urethane mit NCO-Funktionalitäten von 1,9 bis 2,1 und zahlenmittleren Molmassen von 1900 bis 4100 g/Mol, hergestellt aus aliphatischen Isocyanatfunktionellen Verbindungen und oligomeren oder polymeren Polyolen und Allophanate mit Funktionalitäten von größer 2,0 bis 3,2 oder von 3,9 bis 4,2.mit zahlenmittleren Molmassen von 1900 bis 4100 g/Mol, hergestellt aus aliphatischen Isocyanat-funktionellen Verbindungen und oligomeren oder polymeren Polyolen oder deren beliebige Mischungen.

Bevorzugt weisen die vorstehend beschriebenen Prepolymere Restgehalte an freiem monomeren Isocyanat von weniger als 1 Gew.-%, besonders bevorzugt weniger als 0,5 Gew.-%, ganz besonders bevorzugt weniger als 0,2 Gew.-% auf.

Selbstverständlich kann Komponente A) anteilsmäßig neben den beschriebenen erfindungswesentlichen Prepolymeren weitere Isocyanate enthalten. Hierfür kommen in Betracht aromatische, araliphatische, aliphatische und cycloaliphatische Di-, Tri- oder Polyisocyanate verwendet. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat (TMDI), die isomeren Bis(4,4'-isocyanatoeyclohexyl)methane und deren Mischungen beliebigen Isomerengehalts, Isocyanatomethyl-1,8-octandiisocyanat, 1,4-Cyclohexylendiisocyanat, die isomeren Cyclohexandimethytendiisocyanate, 1,4-Phenylendiisocyanat, 2,4- und/oder 2,6-Toluylendiisocyanat, 1,5-Naphthylendiisocyanat, 2,4'- oder 4,4'-Diphenytmcthandiisocyanat, Triphenylmethan-4,4',4"-triisocyanat oder deren Derivate mit Urethan-, Hamstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die vorgenannten Isocyanatkomponente A) vollständig oder anteilsmäßig Isocyanate enthält, die ganz oder teilweise mit dem Fachmann aus der Beschichtungstechnologie bekannten Blorkierungsmitteln umgesetzt sind. Als Beispiel für Blookierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, $\varepsilon$-Caprolactam, N-tert-Butyl-benzylamin, Cyclopentanoncarboxyethylester oder beliebige Gemische dieser Blockierungsmittel.

Bevorzugt werden in A) ausschließlich die oben beschriebenen erfindungswesentliellen Prepolymere eingesetzt.

Als Komponente B) können an sich alle polyfunktionellen, isocyanatreaktiven Polyetherpolyole eingesetzt werden, die bevorzugt im Mittel wenigstens 1,5 isocyanatreaktive-Gruppen pro Molekül aufweisen.

Isocyamitreaktive Gruppen im Rahmen der vorliegenden Erfindung sind bevorzugt Hydroxyverbindungen.

Geeignete polyfunktionelle, isocyanatreaktive Verbindungen der vorstehend genannten Art sind beispielsweise Polyester-, Polyether-, Polycarbonat-, Poly(meth)acrylat- und/oder Polyurethanpolyole, bevorzugt hydroxyfunktionelle Polyetherpolyole.

Polyetherpolyole sind gegebenenfalls blockweise aufgebaute Polyadditionsprodukte cyclischer Ether an OH-funktionelle Startermoleküle. Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können mehrwertigen Alkohole einer OH-Funktionalität $\geq$ 2 sowie primäre oder sekundäre Amine und Aminoalkohole verwendet werden. Beispiele dafür sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiot. 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Solche Polyetherpolyole haben bevorzugt zahlenmittlere Molmassen von 500 bis 8500 g/Mol, besonders bevorzugt von 1000 bis 6500 g/Mol und ganz besonders bevorzugt von 1900 bis 4500 g/Mol. Die OH-Funktionalität beträgt bevorzugt 1,5 bis 4,0, besonders bevorzugt 1,8 bis 3,0.

Daneben kann Komponente B) auch niedermolekulare, d.h. mit Molekulargewichten kleiner 500 g/Mol, kurzkettige, d.h. 2 bis 20 Kohlenstoffatome enthaltende aliphatische, araliphatische oder cyeloaliphatischc di-, tri- oder polyfunktionelle Alkohole enthalten. Bevorzugt ist der Einsatz reiner hydroxyfunktioneller Polyetherpolyole.

Bevorzugte Verbindungen der Komponente B) sind Poly(propylenoxid)e, Poly(ethylenoxide) und deren Kombinationen in Form von statistischen oder Blockcopolymeren sowie Blockcopolymere aus Propylenoxid und/oder Ethylenoxid. Dabei ist der Ethylenoxidanteil bezogen auf Gewichtsprozent des gesamten Produktes bevorzugt kleiner als 55%, besonders bevorzugt entweder zwischen 55% und 45% oder kleiner als 30% und ganz besonders bevorzugt kleiner als 10%.

Als ganz besonders bevorzugte Verbindungen der Komponente B) sind difunktionelle Polyetherpolyole, basierend auf Propylenoxid und Ethylenoxid mit einem Ethylenoxidanteil von kleiner 10 Gewichtsprozent bezogen auf die Gesamtmasse des zugrundeliegenden Polyethers, und einer zahlenmittleren Molmasse zwischen 2000 und 4200 g/mol eingesetzt.

Die Komponenten A) und B) werden bei der Herstellung der Photopolymerformulierung in einem OH/NCO-Verhältnis zueinander eingesetzt von typischerweise 0,9 bis 1,2, bevorzugt 0,95 bis 1,05.

In Komponente C) werden Urethanacrylate und/oder Urethanmethacrylate mit mindestens einer aromatischen Struktureinheit und einem Brechungsindex von größer 1,50 bei 405 nm eingesetzt. Unter Urethan(meth)acrylaten versteht man Verbindungen mit mindestens einer Acrylat- bzw. Methacrylatgruppe, die zusätzlich über mindestens eine Urethanbindung verfügen. Es ist bekannt, dass solche Verbindungen durch Umsetzung eines Hydroxy-funktionellen (Meth)Acrylsäureesters mit einer Isocyanat-funktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (TPDI), 1,8-Diisocyanato-4. (isocyanatomethyl)oktan, 2,2,4- und/oder 2,4,4-Trimethythexamcthylendiisocyanat, die isomeren Bis(4,4'-isocyanatocyclohexyl)methane und deren Mischungen beliebigen Isomerengehalts, Isocyanatoinethyl-1,8-octandiisocyanat, 1,4-Cyclohexylendiisocyanat, die isomeren Cyclohexandimethyletidiisocyanate, 1,4-Phenylendiisocyanat, 2,4- und/oder 2,6-Toluylcndiisocyanat, 1,5-Naphthytendiisocyanat, 2,4'- oder 4,4'-Diphenyhnethandiisocyanat, 1,5-Naphthylendiisocyanat, Triphonylmethan-4,4',4''-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxidmono(meth)-acrylate, Poly($\varepsilon$-caprolacton)mono(meth)acrylate, wie z.B. Tone® M 100 (Dow, Schwalbach, DE), 2-Hydroxypropyl(meth)acrylat, 4-Hydroxybutyl(meth)acrylat, 3-Hydraxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly($\varepsilon$-caprolacton)mono(meth)acrylate. Darüberhinaus sind als isocyanat-reaktive oligomere oder polymere ungesättigte Acrylat- und/oder Methaerylatgruppen enthaltende Verbindungen alleine oder in Kombination mit den vorgenannten monomeren Verbindungen geeignet. Ebenfalls verwendet werden können die an sich bekannten hydroxytgruppcnhaltigen Epoxy(meth)acrylatc mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehahen von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)aerylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylierten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.

Bevorzugt werden Urethan(meth-)acrylate der vorstehend genannten Artverwendet, die mindestens eine aromatische Struktureinheit aufweisen. Diese Urethan(meth-)acrylate besitzen Brechungsindizes von typischerweise größer 1,50, bevorzugt größer 1,55 und ganz besonders bevorzugt größer 1,58 bei 405 nm.

Besonders bevorzugte als Komponente C) zu verwendende Verbindungen sind Urethanacrylate und Urethanmethacrylate auf Basis aromatischer Isocyanate und 2-Hydroxyethylacrylat, Hydroxypropylacrylat, 4-Hydroxybutylacrylat Polyethylenoxid-mono(meth)acrylat, Polypropylenoxid-mono(moth)acrylat, Polyalkylenoxidmono(meth)acrylat und Poly($\varepsilon$-caprolacton)mono(meth)-acrylate.

In einer ganz besonders bevorzugten Ausführungsform werden als Komponente C) die Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat eingesetzt. In einer weiteren ganz besonders bevorzugten Ausführungsform werden als Komponente C Additionsprodukte von 3-Thiomethyl-phenylisocyanat mit Hydroxyethylacrylat, Hydroxypropylacrylat, 4-Hydroxybutylacrylat eingesetzt.

Als Verbindungen der Komponente D) geeignet sind beispielsweise Inhibitoren und Antioxidantien wie sie z.B. in "Methoden der organischen Chemie" (Houbeil-Weyl), 4. Auflage, Band XIV/1, S. 433ff, Georg Thieme Verlag, Stuttgart 1961, beschrieben sind. Geeignete Stoffklassen sind beispielsweise Phenole wie z,B. 2,6-Di-tert-butyl-4-mothylphenol, Kresole, Hydrochinone, Benzylalkohole wie z.B. Benzhydrol, ggf. auch Chinone wie z. B. 2,5-Di-*tert*.-Butylchinon, ggf, auch aromatische Amine wie Diisopropylamin oder Phenothiazin.

Bevorzugt sind 2,6-Di-*tert*.-butyl-4-methylphenol, Phenothiazin, p-Methyoxyphenol, 2-Methoxy-p-hydrochinon und Benzhydrol.

Als Komponente E) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ 1) und bimolekularen (Typ II) initiatoren unterschieden wird. Desweiteren werden diese Initiatoren je nach chemischer Natur für die radikalische, die anionische (oder), die kationisehe (oder gemischte) Formen der vorgenannten Polymerisationen eingesetzt.

Hier eingesetzt werden Typ II-Initiatoren wie die in EP-A 0223587 beschriebenen Photoinitiatorsysteme bestehend aus einer Mischung aus einem Ammoniumarylborat und einem oder mehreren Farbstoffen. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium 1, Cyanin und Methylenblau, Azur A (Cunningham et al., RadTech'98 North America UV/EB Conference Proceedings, Chicago, Apr. 19-22, 1998).

Bevorzugte Photoinitiatoren E) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat (Komponente E1)) mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin (Komponentc E2)). Insbesondere bevorzugt ist die Kombination von je einem blau-sensitiven, einem grün-sensitiven sowie einem rot-sensitiven Farbstoff (z.B. Astrazon Orange G, Ethylviolett und Neu Methylenblau) und einem der vorgenannten Boratsalze.

Als Verbindungen der Komponente F) können gegebenenfalls ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1-oxoneodecyl)oxy]stannan, Dimethylzinndicarboxylat, Zirkonium-bis(ethyl-hexanoat), Zirconium-acteylacetonat oder tertiäre Aminen wie beispielsweise 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Dimethylbis[(1-oxoncodecyl)oxy]stannan, Dimethylzinndicarboxylat, 1,4-Diazabieyclo[2.2.2]octan, Diazabicyclononan, Diazabicycloundecan, 1,1,3,3-Tetramcthylguanidin, 1,3,4,6,7,8-Hexahydro-1-methyl-2H-pyrimido(1,2-a)pyrimidin.

Selbstverständlich können gegebenenfalls weitere Zusatzstoffe G) eingesetzt werden. Dabei kann es sich beispielsweise um im Bereich der Lacktechnologie gängige Zusatzstoffe wie Lösemittel, Weichmacher, Verlaufsmittel, Entschäumungsmittel oder Haftvermittler handeln. Als Weichmacher werden dabei bevorzugt Flüssigkeiten mit guten Löseeigenschaften, geringer Flüchtigkeit und hoher Siedetemperatur eingesetzt. Als Verlaufsmittel können oberflächenaktive Verbindungen wie z.B. Polydimethylsiloxane verwendet werden. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Typische Photopolymerzusammensetzungen umfassen:

10 bis 30 Gew,-% der Komponenten A),

25 bis 79,497 Gew.-% der Komponente B),

10 bis 40 Gew.-% der Komponente C)

0 bis 1 Gew.-% Radikalstabilisatoren D)

0.5 bis 3 Gew.-% Photoinitiatoren E1)

jeweils 0,001 bis 0,2 Gew.-% der drei Farbstoffe E2), die im Absorptionsspektrum auf die Laserwellenlängen rot, grün und blau abgestimmt sind

0 bis 4 Gew.-% Katalysatoren F)

0 bis 10 Gew.-% Hilfs- und Zusatzstoffe G)

Bevorzugt umfassen die erfindungsgemäßen Polyurethanzusammensetzungen

15 bis 30 Gew.-% der Komponenten A)

30 bis 60,96 Gew.-% der Komponente B),

20 bis 35 Gew.-% der Komponente C)

0,01 bis 0,5 Gew.-% Radikalstabilisatoren D)

1 bis 3 Gew.% Photoinitiatoren E1)

jeweils 0,01 bis 0,2 Gew.-% der drei Farbstoffe E2), die im Absorptionsspektrum auf die Laserwellenlängen rot, grün und blau abgestimmt sind

0 bis 1 Gew.-% Katalysatoren F)

3 bis 8 Gew.-% Hilfs- und Zusatzstoffe G)

Besonders bevorzugt umfassen die erfindungsgemäßen Polyurethanzusammensetzungen

18 bis 30 Gew.-% Komponente A)

40 bis 52,37 Gew.-% der Komponenten B)

25 Gew.-% der Komponente C)

0,02 bis 0,1 Cew.-% Radikalstabilisatoren D)

1 bis 1,5 Gew.-% Photoinitiatoren E1)

jeweils 0,03 bis 0,1 Gew.-% der drei Farbstoffe E2), die im Absorptionsspektrum auf die Laserwellenlängen rot, grün und blau abgestimmt sind

0,02 bis 0,1 Gew.-% Katalysatoren F)

3,5 bis 5 Gew.-% Hilfs- und Zusatzstoffe G)

Die erfindungsgemäßen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 10000 mPas, insbesondere bevorzugt 500 bis 5000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die mit einem Katalysatorgehalt von 0,004 Gew.-% bis 0,1 Gew.-% bei 80°C unter 6 Minuten aushärten, bevorzugt werden Konzentrationen zwischen 0,01 Gew.-% und 0,08 Gew.-%, besonders bevorzugt werden Konzentrationen zwischen 0,03 Gew.-% und 0,06 Gew.-%.

Zur Applikation auf ein Substrat bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck. Bevorzugt sind Rakel und Schlitzdüsen als Applikationsverfahren geeignet.

Ein weiterer Gegenstand der vorliegenden Erfindung sind Photopolymere erhältlich aus den erfindungsgemäßen Polyurethanformulierungen und deren Verwendung zur Herstellung optischer Artikel insbesondere von Medien geeignet zur Aufzeichnung von Hologrammen

Ein weiterer Gegenstand der vorliegenden Erfindung ist auch ein Verfahren zur Herstellung solcher Medien zur Aufzeichnung visueller Hologramme, bei dem ein oder mehrere der erfindungswesentlichen Polyurethanfonnulierungen auf ein Substrat oder in eine Form appliziert und ausgehärtet werden. Ebenfalls ein Gegenstand der Erfindung sind die so erhältlichen Medien.

Solche Medien können Folienverbunde aus mindestens einer Begussfolie oder Trägerschicht (I), einer oder mehrerer Photopolymerschichten (II) basierend auf den erfindungswesentlichen Polyurethanfotmulierungen sowie einer Deck- oder Kaschierfolie (III). Im Folienverbund können weitere Folien enthalten sein.

Die erfindunsgemäßen Polyurethanzusammensetzungen werden dabei über ein geeignetes Verfahren auf die Begussfolie oder Trägerschicht (I) appliziert.

Bevorzugte Materialien oder Materialverbünde der Trägerschicht I) basieren auf Polycarbonat (PC), Polyethylenterephthalat (PET), Polybutylenterephthalat, Polyethylen, Polypropylen, Celluloseacetat, Cellutosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Daneben können Materialverbünde wie Folienlaminate oder Coextrudate als Trägerfolie (I) Anwendung finden. Beispiele für Materialverbünde sind Duplex- und Triplexfolien aufgebaut nach einem der Schemata A/B, A/B/A oder A/B/C wie PC/PET, PET/PC/PET und PC/TPU (TPU = Thermoplastisches Polyurethan). Besonders bevorzugt wird PC und PET als Trägerfolie (I) verwendet

Bevorzugt sind transparente Träger I), die optisch klar, d.h. nicht trüb sind. Die Trübung (engl. Haze) ist messbar über den Haae-Wert, welcher kleiner als 3,5%, bevorzugt kleiner als 1%, besonders bevorzugt kleiner als 0,3% ist.

Der Haze-Wert beschreibt den Anteil des transmittierten Lichts, der von der durchstrahlten Probe nach vorne gestreut wird. Somit ist er ein Maß für die Opazität oder Trübung transparenter Materialien und quantifiziert Materialfehler, Partikel, Inhomogenitäten oder kristalline Phasengrenzen in dem Material oder seiner Oberfläche, die die klare Durchsicht stören. Das Verfahren zur Messung der Trübung wird in der Norm ASTM D 1003 beschrieben.

Bevorzugt weist der Träger I) eine nicht zu hohe Doppelbrechung auf, d.h. typischerweise eine mittlere optische Retardation von weniger als 1000 nm, bevorzugt von weniger als 700 nm, besonders bevorzugt von weniger als 300 nm auf.

Die Retardation R ist das mathematische Produkt aus der Doppelbrechung Δn und der Dicke des Trägers d. Die automatische und objektive Messung der Retardation erfolgt mit einem bildgebenden Polarimeter, z.B. von der Firma ilis GmbH, Modell Stainmatic® M3/M.

Die Retardation wird in senkrechter Inzidenz gemessen, Die für den Träger I) angegebenen Werte für die Retardation sind laterale Mittelwerte.

Der Träger I) hat, einschließlich eventueller ein oder beidseitiger Beschichtungen, typischerweise eine Dicke von 5 bis 2000 μm, bevorzugt 8 bis 300 μm, besonders bevorzugt 30 bis 200 μm und insbesondere 125 bis 175 μm oder 30 bis 45 μm.

Die Photopolymerlagen II) haben bevorzugt eine Gesamtschichtdicke bezogen auf alle in Schicht II) aufgebrachten Photopolymerlagen von höchstens 200 μm, besonders bevorzugt 3 bis 100 μm, ganz besonders bevorzugt 15 bis 60 μm,

Zusätzlich zu den Bestandteilen I) und II) können für den Folienverbund ein oder mehrere Abdeckschichten III) auf der Photopolymerschicht 11) aufweisen, um diese vor Schmutz und Umwelteinflüssen zu schützen. Hierzu können Kunststofffolien oder Folienverbundsysteme, aber auch Klarlacke verwendet werden.

Als Abdeckschichten III) werden bevorzugt Folienmaterialien analog den in der Trägerschicht eingesetzten Materialien verwendet, wobei diese eine Dicke von typischerweise 5 bis 200 μm, bevorzugt 8 bis 125 μm, besonders bevorzugt 20 bis 50 μm.

Bevorzugt sind Abdeckschichten III) mit einer möglichst glatten Oberfläche. Als Maß gilt die Rauigkeit bestimmt nach DIN EN ISO 4288 "Geometrische Produktspezifikation (GPS) - Oberflächenbeschaffenheit..." (engl. "Geometrical Product Specifications (GPS) - Surface texture...", Prüfbedingung R3z Vorderseite und Rückseite. Bevorzugte Rauigkeiten liegen im Bereich kleiner oder gleich 2 μm, bevorzugt kleiner oder gleich 0,5 μm.

Als Kaschierfolien (III) werden bevorzugt PE- oder PET-Folien einer Dicke von 20 bis 60 μm verwendet, besonders bevorzugt wird eine Polyethylenfolie von 40 μm Dicke verwendet.

Es können weitere Schutzschichten, so z.B. eine untere Kaschierung der Trägerfolie (I) Anwendung finden.

Das erfindungsgemäße Verfahren der Medienherstellung wird bevorzugt derart durchgeführt, dass die Aufbaukomponenten der erfindungsgemäßen Polyurethanzusammensetzungen mit Ausnahme der Komponente A) miteinander homogen vermischt werden und unmittelbar vor der Applikation auf das Substrat oder in die Form erst Komponente A) zugemischt wird.

Für die Förderung und die benötigte Genauigkeit beim Dosieren eignen sich alle dem Fachmann bekannten Pumpensysteme, die im Speziellen gegendruckunabhängig, pulsationsarm und präzise fördern, Bevorzugt werden demnach Membranpumpe, Zahnradpumpen, Excenterschneckenpumpen (Mohnopumpen), Schlauchpumpen und Kolbenpumpen. Besonders bevorzugt sind Zahnradpumpen und Excenterschneckenpumpen (Mohnopumpen).

Bevorzugte Dosiermengen sind im Bereich von 2 ml/min bis 1.000 ml/min, besonders bevorzugt im Bereich von 2 ml/min bis 100 ml/min.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente A) ist bevorzugt, um Blasenbildung durch Restgase in den erhältlichen Medien zu verhindern.

Vor Zumischung der Komponente A) können die Mischungen als lagerstabiles Zwischenprodukt gegebenenfalls über mehrere Monate gelagert werden kann.

Nach der Zumischung der Komponente A) der erfindungsgemäßen Polyurethanzusammensetzungen wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der PolyurethanzusammenSetzungen wird bevorzugt so eingestellt, dass die Aushärtung nach Zumischung der Komponente A) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann leicht in Form von Routineversuchen innerhalb der oben angegebenen Mengenbereich der Komponenten sowie der jeweils zur Auswahl stehenden, insbesondere den bevorzugten Aufbaukomponenten, leicht möglich.

Ein weiterer Gegenstand der vorliegenden Erfindung ist die Verwendung der erfindungsgemäßen Medien zur Aufzeichnung visueller Hologramme, zur Herstellung von optischen Elementen, Bildern, Darstellungen sowie ein Verfahren zur Aufzeichnung von Hologrammen unter Verwendung der erfindungsgemäßen Polyurethanzusammensetzungen und den daraus zugänglichen Medien oder holographischen Filmen.

Mit den erfindungsgemäßen Polyurethanzusammensetzungen können durch entsprechende Belichtungsprozesse Hologramme für optische Anwendungen im gesamten sichtbaren Bereich sowie im nahen UV-Bereich (300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reftektionshotogramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken haben. Häufig zeigen diese optischen Elemente eine Frequenzselektivität je nachdem wie die Hologramme belichtet wurden und welche Dimensionen das Hologramm hat.

Zudem können mittels der erfindungsgemäßen Polyurethanzusammensetzungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältige Designmöglichkeiten stellen Hologramme, insbesondere Volumenhologramme, eine attraktive technische Lösung für die oben genannten Anwendung dar.

**Beispiele:**

Einsatzstoffe:

Desmodur® XP 2599 ist ein Versuchsprodukt der Bayer MaterialScience AG, Leverkusen, DE, Vollallophanat von Hexandiisocyanat auf Acclaim 4200, NCO-Gehalt: 5,6 - 6,4 %

Prepolymer 1 ist ein experimentelles Produkt der Bayer MaterialScience AG, Leverkusen, DE, Urethan von Hexandiisocyanat und Acclaim 2200, NCO-Gehalt: 3,2 - 3,75 %

Polyol 1 (Acclaim® 4200) ist ein Polypropylenoxid der zahlenmittleren Molmasse 4000 g/Mol der Bayer MaterialSoience AG, Leverkusen, DE.

Polyol 2 (Acclaim® 4220 N) ist ein ethylenoxid-gecapptes Polypropylenoxid der zahlenmittlere Molmasse 4000 g/Mol der Bayer MaterialScience AG, Leverkusen, DE.

Polyol 3 (Acclaim® 2200) ist ein Polypropylenoxid der zahlenmittleren Molmasse 2000 g/Mol der Bayer MaterialScience AG, Leverkusen, DE.

Urethanacrylat 1 ist ein experimentelles Produkt der Bayer MaterialScience AG, Leverkusen, DE, Urethanacrylat auf Basis von HEA und Tris(p-isocyanatophenyl)thinphosphat.

Fomrez® UL28: Urethanisierungskatalysator, Dimethylbis[(1-oxoneodccl)oxy]stannan, Handelsprodukt der Fa. Momentive Performance Chemicals, Wilton, CT, USA (als 10%ige Lösung in N-Ethylpyrrolidon eingesetzt).

CGI 909: Co-Initiator auf Boratbasis der Firma Ciba Inc., Basel, Schweiz.

Neu Methylenblau (zinkfrei): Farbstoff der Fa. Sigma-Aldrich Chemie GmbH, Steinheim, Deutschland.

Ethylviolett: Farbstoff der Fa.MP Biomedicals LLC, Solon, Ohio, USA.

Astrazon Orange G: Farbstoff der Fa. Sigma-Aldrich Chemie GmbH, Steinheim, Deutschland.

Byk 310: silikonbasiertes Oberflächenadditiv der Fa. BYK-Chemie GmbH, Wesel, Deutschland (Lösung ca. 25%-ig in Xylol), zahlenmittlere Molmasse ca. 2200 g/mol.

### Messung von Beugungswirkungsgrad DE und Brechungsindexkontrast An:

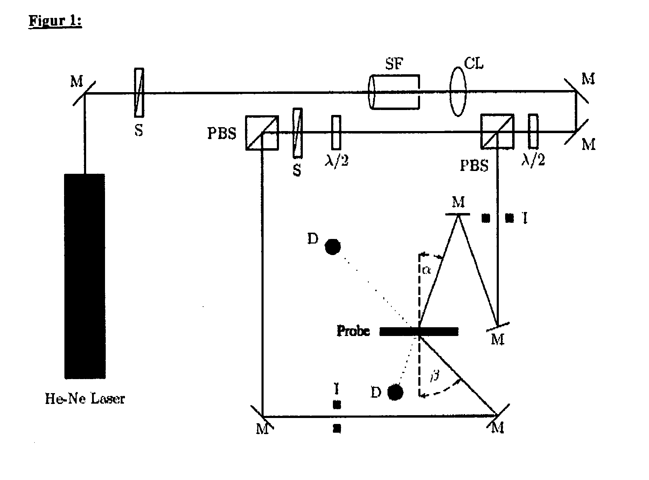

Die im Rahmen des experimentellen Teils hergestellten erfindungsgemäßen und Vergleichsmedien wurden mittels einer Messanordnung gemäß Figur 1 auf ihre holographischen Eigenschaften geprüft:

Figur 1: Geometrie eines Holographic Media Testers bei $\lambda$ = 633 nm (Ile-Ne Laser)zum Schreiben eines Reflexionshologrammes: M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha$ = 21.8° und $\beta$ = 41.8° sind die Einfallswinkel der kohärenten Strahlen ausserhalb der Probe (des Mediums) gemessen.

Dabei wird die Kaschierfolie vom Folienverbund abgezogen und das Photopolymermaterial anschließend so auf Glas laminiert, dass die Substratfolie nach außen zeigt.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Roferenzstrahls werden durch die Irisblenden (I) festgelegt. Der Durchmesser der Irisblendenöffnung beträgt 4 mm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel ($\alpha$) des Referenzstrahls beträgt 21.8°, der Einfallswinkel ($\beta$) des Signalstrahls beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand im Medium beträgt ~ 225 nm (Brechungsindex des Mediums zu ~1.49 angenommen).

Es wurden auf folgende Weise Hologramme in das Medium geschrieben:

Beide Shutter (S) sind für die Belichtungszeit t geöffnet. Danach wurde bei geschlossenen Shuttern (S) dem Medium 5 Minuten Zeit für die Diffusion der noch nicht polymerisierten Schreibmonomere gelassen. Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega$ = 0° bis $\Omega$ = 20° mit einer Winkelschrittweite von 0.05°. An jedem angefahrenen Winkel wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz $\eta$ ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$ des geschriebenen Hologramms gemessen und in einem Computer gespeichert. Zusätzlich wurde auch die in die nullte Ordnung transmittierte Intensität gegen der Drehwinkel $\Omega$ aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast $\Delta n$ und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve $\eta/(\Omega)$ eines Reflexionshologramms gilt nach Kogelnik:

$$\eta = \frac{1}{1 + \frac{1 - (\chi/\Phi)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha' - \psi)}{\Lambda \cdot \cos(\alpha' - 2\psi)} \cdot \frac{d}{2}$$

$$\psi = \frac{\beta' - \alpha'}{2}$$

$$\Lambda = \frac{\lambda}{2 \cdot n \cdot \cos(\psi - \alpha')}$$

$$n \cdot \sin(\alpha') = \sin(\alpha), \, n \cdot \sin(\beta') = \sin(\beta)$$

$$\Delta\theta = -\Delta\Omega \cdot \sqrt{\frac{1 - \sin^2(\alpha)}{n^2 - \sin^2(\alpha)}}$$

$\Phi$ ist die Gitterstärke, $\chi$ ist der Detuning Parameter und $\Psi$ der Kippwinkel des Brechungsindexgitters, das geschrieben wurde, $\alpha'$ und $\beta'$ entsprechen den Winkeln $\alpha$ und $\beta$ beim Schreiben des Hologramms, aber im Medium. $\Delta\Theta$ ist das Winkeldetuning gemessen im Medium, also die Abweichung vom Winkel $\alpha'$. $\Delta\Omega$ ist das Winkeldetuning gemessen außerhalb des Mediums, also die Abweichung vom Winkel $\alpha$, n ist der mittlere Brechungsindex des Photopolymers und wurde zu 1.504 gesetzt.

Die maximale Beugungseffizienz (DE = $\eta_{max}$) ergibt sich dann für $\chi = 0$, also $\Delta\Omega = 0$ zu:

$$DE = \tanh^2(\Phi) = \tanh^2\left(\frac{\pi \cdot \Delta n \cdot d}{\lambda \cdot \sqrt{\cos(\alpha') \cdot \cos(\alpha' - 2\psi)}}\right)$$

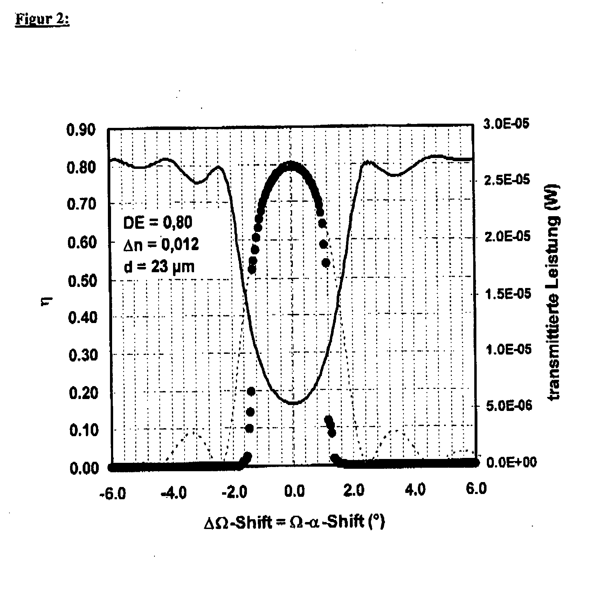

Die Messdaten der Beugungseffizienz, die theoretische Braggkurve und die transmittierte Intensität werden wie in Figur 2 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta$n wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Hologrammen (kleines d) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 2: Darstellung der Braggkurve $\eta$ nach Kogelnik (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt:

$$E \, (\mathrm{mJ/cm^2}) = \frac{2 \cdot [0.50 \, \mathrm{mW} + 0.67 \, \mathrm{mW}] \cdot t \, (\mathrm{s})}{\pi \cdot 0.4^2 \, \mathrm{cm^2}}$$

Die Leistungen der Teilstrahlen wurden so angepasst, dass in dem Medium bei den verwendeten Winkeln $\alpha$ und $\beta$, die gleiche Leistungsdichte erreicht wird.

Alternativ wurde auch ein dem in Abbildung 1 dargestellten Aufbau äquivalenter Test mit einem grünen Laser mit der Emissionswellenlänge $\lambda$ im Vakuum von 532 nm durchgeführt. Dabei beträgt $\alpha$ = 11.5° und $\beta$ = 33.5° und $P_\alpha$ = 1.84 mW und $P_\beta$ = 2.16 mW.

## Herstellung des Urethanacrylates 1:

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) sowie und 213.07 g einer 27 %-igen Lösung von Tris (p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

Zur Herstellung der holographischen Medien werden die Komponente C, die Komponente D (die bereits in der Komponente C vorgelöst sein kann) sowie gegebenenfalls die Komponente G und F in der Komponente B gegebenenfalls bei 60 °C gelöst und gründlich gemischt. Danach wird im Dunkeln oder unter geeigneter Beleuchtung die Komponente E in reiner Form oder in verdünnter Lösung in NEP zugewogen und erneut gemischt. Gegebenenfalls wird maximal 10 Minuten im Trockenschrank auf 60 °C erhitzt. Die erhaltene Mischung kann unter Rühren bei < 10 mbar entgast werden.

Die Komponente A kann ebenfalls unter Rühren bei < 10 mbar entgast werden. Anschließend werden beide Formulierungen mittels Zwangsdosierpumpen über einen der oben genannten Mischverfahren kontinuierlich dosiert und vermischt. Danach wird die Mischung über eine Applikationseinheit, wie z.B. ein Rakel oder eine Schlitzdüse kontinuierlich und homogen auf ein Substrat appliziert.

Die beschichteten Substrate werden bei ca. 80 °C getrocknet und anschließend mit einer der oben genannten Abdeckschichten abgedeckt und in einer lichtdichten Verpackung verpackt.

Die Dicke d der Photopolymerschicht ergibt sich aus den dem Fachmann bekannten Beschichtungsparametern der entsprechenden Beschichtungseinrichtung.

Die folgenden Beispiele sind zur Erläuterung der erfindungsgemäßen Methode genannt, sollen aber nicht als begrenzend verstanden sein. Sofern nicht abweichend vermerkt beziehen sich alle Prozentangaben der Photopolymere auf Gewichtsprozent.

**Beispiel 1:**

27,83 g Polyol 1 (Komponente B) wurden schrittweise mit 13,75 g Urethanacrylat 1 (Komponente C), dann 0.275 g Fomrez® UL 28 (Komponente F) und 0,165 g Byk 310 (Komponente G), und zuletzt einer Lösung von 0,825 g CGI 909, 0.028 g Neu Methylenblau, 0,028 g Ethylviolett und 0,028 g Astrazon Orange G (zusammen Komponente E) in 1,678 g N-Ethylpyrilidon (Komponente G) im Dunkeln versetzt und gemischt, so dass eine klare Lösung erhalten wurde. Anschließend wurden bei 30 °C 10,395 g Desmodur® XP 2599 (Komponente A) zugegeben und erneut gemischt. Die erhaltene, flüssige Masse wurde dann auf eine 175 $\mu$m dicke Polycarbonatfolie appliziert und 4,5 Minuten bei 80°C getrocknet. Trockenschichtdicke: 45$\mu$m, maximaler $\Delta$n: 0,016 (633 nm); 0,017 (532 nm).

**Beispiel 2:**

10,245 g Polyol 2 (Komponente B) wurden schrittweise mit 5,00 g Urethanacrylat 1 (Komponente C), dann 0,100 g Fomrez® UL 28 (Komponente F) und 0,060 g Byk 310 (Komponente G), und zuletzt einer Lösung von 0,300 g CGI 909, 0.010 g Neu Methylenblau, 0,010 g Ethylviolett und 0,010 g Astrazon Orange G (zusammen Komponente E) in 0,610 g N-Ethylpyrilidon (Komponente G) im Dunkeln versetzt und gemischt, so dass eine klare Lösung erhalten wurde. Anschließend wurden bei 30 °C 3,655 g Desmodur® XP 2599 (Komponente A) zugegeben und erneut gemischt. Die erhaltene, flüssige Masse wurde dann auf eine 175 $\mu$m dicke Polycarbonatfolie appliziert und 4,5 Minuten bei 80°C getrocknet. Trockenschichtdicke: 25 $\mu$m, maximaler $\Delta$n: 0,012 (633 nm); 0,010 (532 nm).

**Beispiel 3**

19,946 g Polyol 3 (Komponente B) wurden schrittweise mit 13,75 g Urethanacrylat 1 (Komponente C), dann 0.275 g Fomrez® UL 28 (Komponente F) und 0,165 g Byk 310 (Komponente G), und zuletzt einer Lösung von 0,825 g CGI 909, 0.028 g Neu Methylenblau, 0,028 g Ethylviolett und 0,028 g Astrazon Orange G (zusammen Komponente E) in 1,678 g N-Ethylpyrilidon (Komponente G) im Dunkeln versetzt und gemischt, so dass eine klare Lösung erhalten wurde. Anschließend wurde bei 30 °C eine Mischung aus 6,467 g Desmodur® XP 2599 und 11,812 g Prepolymer 1 (zusammen Komponente A) zugegeben und erneut gemischt. Die erhaltene, flüssige Masse wurde dann auf eine 175 $\mu$m dicke Polycarbonatfolie appliziert und 4,5 Minuten bei 80°C getrocknet. Trockenschichtdicke: 32$\mu$m, maximaler $\Delta$n: 0,016 (633 mm); 0,017 (532 nm).

**Beispiel 4**

8,432 g Polyol 3 (Komponente B) wurden schrittweise mit 5,00 g Urethanacrylat 1 (Komponente C), dann 0,100 g Fomrez® UL 28 (Komponente F) und 0,060 g Byk 310 (Komponente G), und zuletzt einer Lösung von 0,300 g CGI 909, 0.010 g Neu Methylenblau, 0,010 g Ethylviolett und 0,010 g Astrazon Orange G (zusammen Komponente E) in 0,610 g N-Ethylpyrilidon (Komponente G) im Dunkeln versetzt und gemischt, so dass eine klare Lösung erhalten wurde. Anschließend wurden bei 30 °C 5,468 g Desmodur® XP 2599 (Komponente A) zugegeben und erneut gemischt. Die erhaltene, flüssige Masse wurde dann auf eine 36 $\mu$m dicke Polyethylenterephthalatfolie appliziert und 4,5 Minuten bei 80°C getrocknet. Trockenschichtdicke: 30$\mu$m, maximaler $\Delta$n: 0,013 (633 nm); 0,014 (532 nm).

**Patentansprüche**

1.  Polyurethanzusammensetzungen, umfassend

    A) eine Polyisocyanatkomponente, wenigstens enthaltend ein NCO-terminiertes Polyurethanprepolymer dessen NCO-Gruppen primär aliphatisch gebunden sind und welches auf hydroxyfunktionellen Verbindungen mit einer OH-Funktionalität von 1,6 bis 2,05 basiert,
    B) Isocyanat-reaktive Polyetherpolyole
    C) Urethanacrylate und/oder Urethanmethacrylate mit mindestens einer aromatischen Struktureinheit und einem Brechungsindex von größer 1,50 bei 405 nm, die selbst frei von NCO-Gruppen und OH-Gruppen sind
    D) Radikalstabilisatoren
    E) Photoinitiatoren auf Basis von Kombinationen aus Boratsalzen und einem oder mehreren Farbstoffen mit Absorptionsbanden, die zumindest teilweise den Spektralbereich von 400 bis 800 nm abdecken.
    F) gegebenenfalls Katalysatoren
    G) gegebenenfalls Hilfs- und Zusatzstoffe.

**2.** Polyurethanzusammensetzungen gemäß Anspruch 1, **dadurch gekennzeichnet, dass** in A) NCO-funktionelle Prepolymere mit Urethan-, Allophanat-, Biuret- und/oder Amidgruppen eingesetzt werden.

**3.** Polyurethanzusammonsetzungen gemäß Anspruch 1 oder 2, **dadurch gekennzeichnet, dass** in A) als isocyanatfunktionelle Prepolymere Urethane oder Allophanate mit zahlenmittleren Molmassen von 650 bis 8200 g/Mol und NCO-Funktionalitäten von 2,0 bis 3,2 oder von 3,9 bis 4,2 aus aliphatischen Isocyanat-funktionellen Verbindungen und oligomeren oder polymeren Polyolen eingesetzt werden.

**4.** Polyurethanzusammensetzungen gemäß einem der Ansprüche 1 bis 3, **dadurch gekennzeichnet, dass** in A) als isocyanatfunktionelle Prepolymere Allophanate mit zahlenmittleren Molmassen von 1900 bis 4100 g/Mol und NCO-Funktionalitäten von 2,0 bis 3,2 oder von 3,9 bis 4,2 aus HDI und difunktionellen Polyetherpolyolen.

**5.** Polyurethanzusammensetzungen gemäß einem der Ansprüche 1 bis 4, **dadurch gekennzeichnet, dass** die in A) als isocyanatfunktionelle Prepolymere eingesetzten Verbindungen Restgehalte an freiem monomerem Isocyanat von weniger als 0,5 Gew.-% aufweisen.

**6.** Polyurethanzusainmemsetzungen gemäß einem der Ansprüche 1 bis 5, **dadurch gekennzeichnet, dass** in Komponente B) Poly(propylenoxid)e, Poly(ethylenoxide) und deren Kombinationen in Form von statistischen oder Blockcopolymeren eingesetzt werden.

**7.** Polyurethanzusammensetzungen gemäß einem der Ansprüche 1 bis 6, **dadurch gekennzeichnet, dass** in Komponente B) difunktionelle Polyetherpolyole, basierend auf Propylenoxid und Ethylenoxid mit einem Ethylenoxidanteil von kleiner 10 Gewichtsprozent bezogen auf die Gesamtmasse des zugrundeliegenden Polyethers, und einer zahlenmittleren Molmasse von 2000 bis 4200 g/mol eingesetzt werden.

**8.** Polyurethanzusammensetzungen gemäß einem der Ansprüche 1 bis 7, **dadurch gekennzeichnet, dass** die in Komponente C) eingesetzten Verbindungen einen Brechungsindex $n_D^{20} > 1,55$ aufweisen.

**9.** Polyurethanzusammensetzungen gemäß einem der Ansprüche 1 bis 8 **dadurch gekennzeichnet, dass** in Komponente C) Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxidmono(meth)acrylat, Polyalkylenoxidmono-(meth)acrylat und Poly(ε-caprolacton)mono(meth)acrylate eingesetzt werden.

**10.** Polyurethanzusammensetzungen gemäß einem der Ansprüche 1 bis 9 **dadurch gekennzeichnet, dass** in Komponente E) Mischungen aus E1) und E2 eingesetzt werden, wobei die Gruppe der Verbindungen E1) aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat und die Gruppe der Verbindungen der Komponente E2) aus Astrazon Orange G, Methylenblau, Neu Methylenblau, Azur A, Pyrillium I, Safranin O, Cyanin, Gallocyanin, Brilliant Grün, Kristallviolett, Ethylviolett und Thionin besteht.

**11.** Verfahren zur Herstellung von Medien zur Aufzeichnung visueller Hologramme, bei dem Polyurethanzusammensetzungen gemäß einem der Ansprüche 1 bis 10 auf ein Substrat oder in eine Form appliziert und ausgehärtet werden.

**12.** Medien zur Aufzeichnung visueller Hologramme erhältlich nach einem Verfahren gemäß Anspruch 11.

**13.** Verwendung von Medien gemäß Anspruch 12 als optische Elemente, Bilder oder zur Bilddarstellung oder -projektion.

**14.** Verfahren zur Aufzeichnung eines Hologramms, bei dem Medien gemäß Anspruch 12 eingesetzt werden.

**Figur 1:**

**Figur 2:**

Europäisches
Patentamt

European
Patent Office

Office européen
des brevets

## EUROPÄISCHER RECHERCHENBERICHT

**Nummer der Anmeldung**

EP 09 00 1951

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | WO 2008/125199 A (BAYER MATERIALSCIENCE AG [DE]; INPHASE TECH INC [US]; STOECKEL NICOLAS) 23. Oktober 2008 (2008-10-23)<br>* Seite 15, Zeilen 18-22 *<br>* Seite 17, Zeilen 17-27 *<br>* Seite 19, Zeilen 20-27 *<br>* Seite 21, Zeile 13 - Seite 22, Zeile 11 *<br>* Seite 23, Zeilen 20-30; Anspruch 12 *<br>----- | 1-14 | INV.<br>C08G18/10<br>C08G18/48<br>C08G18/67<br>C08G18/77<br>C08G18/78<br>G03F7/00<br>G03F7/035<br>G11B7/245<br>G11B7/246<br>G11B7/253 |
| Y | WO 03/014178 A (INPHASE TECH INC [US]) 20. Februar 2003 (2003-02-20)<br>* Absätze [0016], [0033] - [0035], [0053]; Ansprüche 1,3-6,8,12 *<br>----- | 1-14 | |
| Y | WO 03/023520 A (IMATION CORP [US]) 20. März 2003 (2003-03-20)<br>* Seite 10, Zeile 27 - Seite 11, Zeile 26; Ansprüche 1-3,6 *<br>----- | 1-14 | |
| Y | EP 1 002 817 A (SHOWA DENKO KK [JP]) 24. Mai 2000 (2000-05-24)<br>* Absätze [0019], [0076]; Ansprüche 1,9 *<br>----- | 1-14 | RECHERCHIERTE SACHGEBIETE (IPC)<br><br>C08G<br>G03F<br>G11B |

Der vorliegende Recherchenbericht wurde für alle Patentansprüche erstellt

| Recherchenort | Abschlußdatum der Recherche | Prüfer |
|---|---|---|
| München | 29. Juli 2009 | Krätzschmar, Ulrike |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
 
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 09 00 1951

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-07-2009

| Im Recherchenbericht angeführtes Patentdokument | Datum der Veröffentlichung | Mitglied(er) der Patentfamilie | Datum der Veröffentlichung |
|---|---|---|---|
| WO 2008125199 A | 23-10-2008 | US 2008312403 A1 | 18-12-2008 |
| WO 03014178 A | 20-02-2003 | AT 331744 T | 15-07-2006 |
| | | CN 1564834 A | 12-01-2005 |
| | | DE 60212854 T2 | 06-09-2007 |
| | | EP 1414878 A1 | 06-05-2004 |
| | | JP 2004537620 T | 16-12-2004 |
| | | JP 2009025838 A | 05-02-2009 |
| | | US 2003044691 A1 | 06-03-2003 |
| WO 03023520 A | 20-03-2003 | US 2003044690 A1 | 06-03-2003 |
| EP 1002817 A | 24-05-2000 | AT 265481 T | 15-05-2004 |
| | | DE 69916750 D1 | 03-06-2004 |
| | | DE 69916750 T2 | 05-01-2005 |

EPO FORM P0461

Für nähere Einzelheiten zu diesem Anhang : siehe Amtsblatt des Europäischen Patentamts, Nr.12/82

**EP 2 218 743 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6743552 B
- US 6765061 B
- US 6780546 B
- US 20060194120 A
- EP 08017279 A
- EP 08017277 A
- EP 08017273 A
- EP 08017275 A
- EP 0223587 A

**In der Beschreibung aufgeführte Nicht-Patentliteratur**

- **Houbeil-Weyl.** Methoden der organischen Chemie. Georg Thieme Verlag, 1961, vol. XIV/1, 433ff
- **Cunningham et al.** *RadTech'98 North America UV/EB Conference Proceedings,* 19. April 1998
- **H. Kogelnik.** *The Bell System Technical Journal,* November 1969, vol. 48 (9), 2909, 2947